# EUROPEAN PATENT APPLICATION

(11) **EP 4 797 361 A1**
(43) Date of publication of application: **26.08.2026**
(21) Application number: 24914958.4
(22) Date of filing: 21.10.2024
(51) Int. Cl.: H01M 4/66, C23C 16/06, H01M 4/134, H01M 4/80, G01N 15/08

(54) **NEGATIVE-ELECTRODE CURRENT COLLECTOR, BATTERY CELL, BATTERY, AND ELECTRIC APPARATUS**

(30) Priority: 02.01.2024 CN 202410002356
(71) Applicant: Contemporary Amperex Technology (Hong Kong) Limited, Central, Hong Kong (HK)
(72) Inventor: SHAO, Zirui, Ningde, Fujian 352100 (CN); GUAN, Wenhao, Ningde, Fujian 352100 (CN); MA, Li, Ningde, Fujian 352100 (CN)
(74) Representative: Lorenz Seidler Gossel Part. mbB
(86) International application number: PCT/CN2024/126189
(87) International publication number: WO 2025/145741

(57) **Abstract**

A negative electrode current collector, a battery cell, a battery, and an electric apparatus are provided. The negative electrode current collector includes a foam metal substrate, where the foam metal substrate has a mass-specific electrochemically active surface area of 2.5 cm²/g to 20 cm²/g and an electrochemically active volumetric surface area of 22 cm²/cm³ to 180 cm²/cm³. The negative electrode current collector can mitigate dendrite growth, reduce the risk of internal short circuits in the battery, improve the reliability and cycle life of the battery, and enable the battery to undergo high-rate charging.

## Description

### CROSS-REFERENCE TO RELATED APPLICATIONS

The present application claims priority to Chinese Patent Application No. 202410002356.2, filed on January 2, 2024, and entitled "NEGATIVE ELECTRODE CURRENT COLLECTOR, BATTERY CELL, BATTERY, AND ELECTRIC APPARATUS," which is incorporated herein by reference in its entirety.

### TECHNICAL FIELD

The present application relates to a negative electrode current collector, a battery cell, a battery, and an electric apparatus.

### BACKGROUND ART

Compared to ionic batteries, metallic batteries can have higher energy density. However, unlike the negative electrodes of an ionic batteries, the negative electrode of a metallic battery suffers from uneven deposition issues, thereby affecting the reliability and electrochemical performance of the metallic battery.

### SUMMARY OF THE INVENTION

The present application provides a negative electrode current collector, a battery cell, a battery, and an electric apparatus, which can mitigate dendrite growth, decrease the risk of internal short circuits in the battery, improve the reliability and cycle life of the battery, and enable the battery to undergo high-rate charging.

In a first aspect, the present application provides a negative electrode current collector, where the negative electrode current collector includes a foam metal substrate, and the foam metal substrate has a mass-specific electrochemically active surface area of 2.5 cm²/g to 20 cm²/g and an electrochemically active volumetric surface area of 22 cm²/cm³ to 180 cm²/cm³.

Compared to a two-dimensional planar copper foil current collector, the negative electrode current collector of the present application has a larger electrochemically active specific surface area. As a result, during battery charging, the negative electrode can have a higher electrochemically active area. This also allows for a decrease in the current density on the surface of the negative electrode and an improvement in the metal deposition morphology, thereby reducing the risk of internal short circuits in the battery and improving the reliability and cycle life of the battery. In addition, this enables the battery to undergo high-rate charging.

In addition, the electrochemically active specific surface area of the foam metal substrate is not the larger the better. Generally, the foam metal substrate with a larger electrochemically active specific surface area has a higher content of small pores. Since metal deposition exhibits highly selective, it tends to preferentially occur in the pores on the side of the negative electrode close to the separator. In this case, if the electrochemically active specific surface area of the foam metal substrate is too large, the pores on the side of the negative electrode close to the separator may be quickly blocked by the deposited metal. Once the pores on the side of the negative electrode close to the separator are blocked, ions in the electrolyte solution are difficult or even unable to replenish to the internal positions of the negative electrode, thereby decreasing the space utilization of the negative electrode, and also leading to poor electrolyte solution wettability of the negative electrode, thereby deteriorating the cycling performance of the battery.

Therefore, by adjusting the mass-specific electrochemically active surface area of the foam metal substrate of the negative electrode current collector to 2.5 cm²/g to 20 cm²/g and the electrochemically active volumetric surface area to 22 cm²/cm³ to 180 cm²/cm³, embodiments of the present application can decrease the current density on the surface of the negative electrode, adjust the metal deposition morphology during charging, thereby mitigating dendrite growth, decreasing the risk of internal short circuits in the battery, improving the reliability and cycle life of the battery, and enabling the battery to undergo high-rate charging.

In some embodiments, the foam metal substrate has a mass-specific electrochemically active surface area of 3.2 cm²/g to 10 cm²/g and an electrochemically active volumetric surface area of 29 cm²/cm³ to 90 cm²/cm³.

In some embodiments, the foam metal substrate has a mass-specific electrochemically active surface area of 3.2 cm²/g to 5 cm²/g and an electrochemically active volumetric surface area of 29 cm²/cm³ to 45 cm²/cm³.

By further adjusting the mass-specific electrochemically active surface area and electrochemically active volumetric surface area of the foam metal substrate within the above ranges, the battery can have high coulombic efficiency while maintaining good cycling performance and rate performance.

In some embodiments, the number of pores having a pore diameter between 0.5 times an average pore diameter D_{avg} and 1.5 times the average pore diameter D_{avg} in the foam metal substrate is 80% to 90% of a total number of pores in the foam metal substrate; and/or the number of pores having a pore diameter less than 0.5 times the average pore diameter D_{avg} in the foam metal substrate is 4.5% to 12% of the total number of pores in the foam metal substrate; and/or the number of pores having a pore diameter greater than 1.5 times the average pore diameter D_{avg} in the foam metal substrate is 2% to 12% of the total number of pores in the foam metal substrate.

By adjusting the pore diameter distribution of the foam metal substrate within the above ranges, the foam metal substrate can have a higher electrochemically active specific surface area, thereby decreasing the current density on the surface of the negative electrode, adjusting the deposition morphology of the metal, improving the space utilization of the negative electrode, thereby helping to improve the coulombic efficiency, cycling performance, and rate performance of the battery; and the foam metal substrate and the negative electrode current collector can also have good electrolyte solution wettability, thereby enabling the battery to have a long cycle life.

In some embodiments, the foam metal substrate has an average pore diameter D_{avg} of 120 µm to 290 µm.

By adjusting the average pore diameter of the foam metal substrate within the above range, the foam metal substrate can have a higher electrochemically active specific surface area. Moreover, the metal deposition morphology can be adjusted, and the space utilization of the negative electrode can be improved. This helps the battery to have both high coulombic efficiency and good cycling performance and rate performance.

In some embodiments, the foam metal substrate has a maximum pore diameter Dₘₐₓ of 200 µm to 500 µm.

In some embodiments, the foam metal substrate has a ligament width of 5 µm to 100 µm.

By adjusting the ligament width of the foam metal substrate within the above range, the battery can achieve both high coulombic efficiency and good cycling and rate performance.

In some embodiments, the foam metal substrate has a pore density of 135 PPI to 200 PPI.

In some embodiments, the foam metal substrate has a porosity of 65% to 91%.

In some embodiments, the foam metal substrate has an open-cell structure with an open-cell rate greater than or equal to 98%.

In some embodiments, the foam metal substrate has a thickness of 80 µm to 1000 µm.

When the foam metal substrate has a thickness within the above range, the ion diffusion path can be shortened, thereby improving the deposition and stripping activity and space utilization of the negative electrode.

In some embodiments, the metal elements present in the foam metal substrate include one or more of copper, nickel, titanium, aluminum, cobalt, iron, manganese, tin, gold, silver, chromium, zinc, cadmium, lead, platinum, antimony, bismuth, gallium, indium, or palladium.

In some embodiments, the negative electrode current collector further includes an alkali metal affinity layer located on a surface of the foam metal substrate. The alkali metal affinity layer can adjust the metal deposition morphology and mitigate dendrite growth, thereby improving the rate performance and cycling performance of the battery.

In some embodiments, the alkali metal affinity layer includes one or more of Cu₂O or Li₃N.

In some embodiments, the alkali metal affinity layer has a thickness of 50 nm to 5 µm.

In a second aspect, the present application provides a battery cell including the negative electrode current collector according to the first aspect of the present application.

In some embodiments, the battery cell includes at least one of a negative electrode-free lithium metal battery cell or a negative electrode-free sodium metal battery cell.

In a third aspect, the present application provides a battery including the battery cell according to the second aspect of the present application.

In a fourth aspect, the present application provides an electric apparatus including the battery according to the third aspect of the present application, where the battery is used to supply electrical energy.

The electric apparatus of the present application includes the battery provided by the present application, thus having at least the same advantages as the battery.

### DESCRIPTION OF THE DRAWINGS

To more clearly illustrate the technical solutions of the embodiments of the present application, the drawings required for use in the embodiments of the present application are briefly introduced below. It is evident that the drawings described below are merely some embodiments of the present application, and those of ordinary skill in the art can obtain other drawings based on these drawings without creative effort.
FIG. 1 is a schematic diagram of a battery cell according to some embodiments of the present application.
FIG. 2 is an exploded schematic diagram of a battery cell according to some embodiments of the present application.
FIG. 3 shows a schematic diagram of a battery module according to some embodiments of the present application.
FIG. 4 shows a schematic diagram of a battery pack according to some embodiments of the present application.
FIG. 5 is an exploded schematic diagram of the battery pack shown in FIG. 4.
FIG. 6 shows a schematic diagram of an electric apparatus according to some embodiments of the present application.

In the drawings, the drawings are not necessarily drawn to actual scale.

Description of reference signs: 1. battery pack; 2. upper enclosure; 3. lower enclosure; 4. battery module; 5. battery cell; 51. casing; 52. electrode assembly; and 53. cover plate.

### DETAILED DESCRIPTION

Hereinafter, embodiments specifically disclosing the negative electrode current collector, battery cell, battery, and electric apparatus of the present application will be described in detail with appropriate reference to the drawings. However, unnecessary detailed descriptions may be omitted in some cases. For example, detailed descriptions of well-known matters or repeated descriptions of substantially identical structures may be omitted. This is to avoid unnecessarily lengthy descriptions and to facilitate understanding by those skilled in the art. Additionally, the drawings and the following description are provided to enable those skilled in the art to fully understand the present application and are not intended to limit the subject matter recited in the claims.

The "ranges" disclosed in the present application are defined in the form of lower and upper limits, where a given range is defined by selecting a lower limit and an upper limit, and the selected lower and upper limits define the boundaries of a particular range. Ranges defined in this manner may include or exclude endpoints and can be arbitrarily combined, meaning any lower limit can be combined with any upper limit to form a range. For example, if ranges of 60-120 and 80-110 are listed for a specific parameter, it is understood that ranges of 60-110 and 80-120 are also contemplated. Additionally, if minimum range values of 1 and 2 are listed, and maximum range values of 3, 4, and 5 are listed, the following ranges are all contemplated: 1-3, 1-4, 1-5, 2-3, 2-4, and 2-5. In the present application, unless otherwise stated, the numerical range "a-b" represents a shorthand notation for any combination of real numbers between a and b, where both a and b are real numbers. For example, the numerical range "0-5" means that all real numbers between "0-5" have been listed herein, and "0-5" is merely a shorthand notation for these numerical combinations. Additionally, when a parameter is expressed as an integer ≥2, it is equivalent to disclosing that the parameter is, for example, an integer of 2, 3, 4, 5, 6, 7, 8, 9, 10, 11, 12, and so on.

Unless otherwise specified, all embodiments and optional embodiments of the present application can be combined with each other to form new technical solutions, and such technical solutions should be considered included in the disclosure of the present application.

Unless otherwise specified, all technical features and optional technical features of the present application can be combined with each other to form new technical solutions, and such technical solutions should be considered included in the disclosure of the present application.

Unless otherwise specified, all steps in the present application can be performed sequentially or randomly, preferably sequentially. For example, a method including steps (a) and (b) indicates that the method may include steps (a) and (b) performed sequentially, or steps (b) and (a) performed sequentially. For example, if it is mentioned that the method may further include step (c), it means that step (c) can be added to the method in any order, for example, the method may include steps (a), (b), and (c), or steps (a), (c), and (b), or steps (c), (a), and (b).

In the present application, the term "about" is used to describe and explain small variations. When used in conjunction with a numerical value, the term may refer to a variation range of less than or equal to ±5% of the stated value, optionally less than or equal to 1%.

In the present application, the terms "multiple" or "various" refer to two or more.

In the description of the embodiments of the present application, unless otherwise specified, a first feature being "on" or "under" a second feature may mean that the first and second features are in direct contact, or that the first and second features are in indirect contact through an intermediate medium. Moreover, a first feature being "above," "over," or "on top of" a second feature may mean that the first feature is directly above or obliquely above the second feature, or merely that the horizontal height of the first feature is greater than that of the second feature. A first feature being "below," "under," or "beneath" a second feature may mean that the first feature is directly below or obliquely below the second feature, or merely that the horizontal height of the first feature is less than that of the second feature.

Unless otherwise specified, the terms used in the present application have the commonly understood meanings in the art.

Unless otherwise specified, the numerical values of the parameters mentioned in the present application can be measured using various test methods commonly used in the art, for example, they can be measured according to the test methods provided in the embodiments of the present application. Unless otherwise specified, the test temperature for each parameter is 25°C.

The battery mentioned in the embodiments of the present application may be a single physical module including one or more battery cells to provide higher voltage and capacity. For example, the battery mentioned in the present application may include a battery cell, a battery module, or a battery pack, or the like.

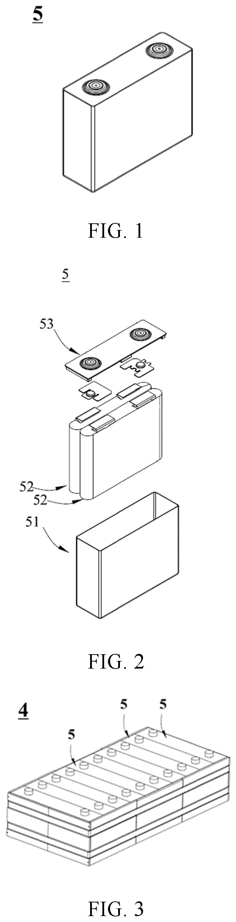

A battery cell is the smallest unit constituting a battery, capable of independently performing charge and discharge functions. The battery cell may be cylindrical, prismatic, or other shapes, which are not limited by the embodiments of the present application. FIG. 1 shows a battery cell 5 with a prismatic structure as an example.

When there are multiple battery cells, the multiple battery cells are connected in series, parallel, or a combination thereof through a busbar component. In some embodiments, the battery may be a battery module; when there are multiple battery cells, the multiple battery cells are arranged and fixed to form a battery module. In some embodiments, the battery may be a battery pack, which includes an enclosure and battery cells, with the battery cells or battery modules accommodated in the enclosure. In some embodiments, the enclosure may form part of the chassis structure of a vehicle. For example, a part of the enclosure may form at least a portion of the chassis of the vehicle, or a part of the enclosure may form at least a portion of the crossbeams and longitudinal beams of the vehicle.

In some embodiments, the battery may be an energy storage device. The energy storage device includes an energy storage container, an energy storage cabinet, and the like.

The battery cell includes an electrode assembly. The electrode assembly may have a wound structure or a stacked structure, which is not limited by the embodiments of the present application.

The battery cell may further include an outer packaging, which can be used to encapsulate the electrode assembly. The outer packaging may be a hard shell, such as a hard plastic shell, aluminum shell, or steel shell. The outer packaging may also be a soft pouch, such as a pouch-type soft package. The material of the soft pouch may be plastic, such as one or more of polypropylene, polybutylene terephthalate (PBT), or polybutylene succinate (PBS).

In some embodiments, as shown in FIG. 2, the outer packaging may include a casing 51 and a cover plate 53. The casing 51 may include a bottom plate and side plates connected to the bottom plate, with the bottom plate and side plates enclosing a receiving cavity. The casing 51 has an opening communicating with the receiving cavity, and the cover plate 53 is used to cover the opening to seal the receiving cavity. The electrode assembly 52 is encapsulated in the receiving cavity. The number of electrode assemblies 52 contained in the battery cell 5 may be one or more, adjustable according to requirements.

In some embodiments, battery cells may be assembled into a battery module, and the number of battery cells in the battery module may be multiple, with the specific number adjustable based on the application and capacity of the battery module. FIG. 3 is a schematic diagram of a battery module 4 as an example. As shown in FIG. 3, in the battery module 4, multiple battery cells 5 may be arranged sequentially along the length direction of the battery module 4. Alternatively, they may be arranged in any other manner. The multiple battery cells 5 may further be fixed by fasteners.

Optionally, the battery module 4 may further include a housing with an accommodating space, in which the multiple battery cells 5 are accommodated.

In some embodiments, the above battery module may be further assembled into a battery pack, and the number of battery modules in the battery pack may be adjusted based on the application and capacity of the battery pack.

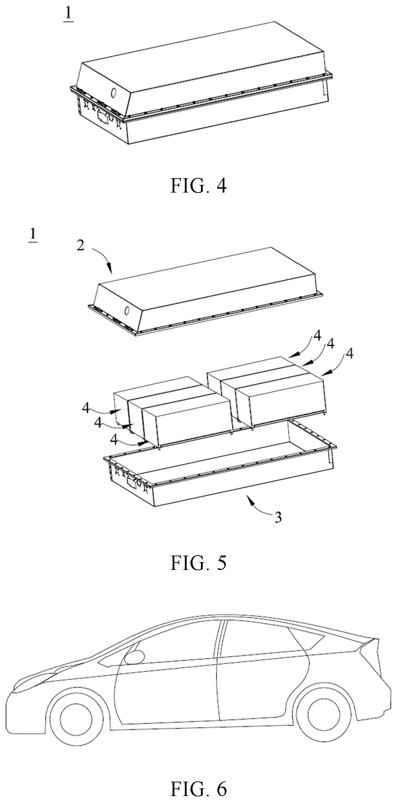

FIG. 4 and FIG. 5 are schematic diagrams of a battery pack 1 as an example. As shown in FIG. 4 and FIG. 5, the battery pack 1 may include an enclosure and multiple battery modules 4 disposed within the enclosure. The enclosure includes an upper enclosure 2 and a lower enclosure 3, where the upper enclosure 2 is used to cover the lower enclosure 3, forming a closed space for accommodating the battery modules 4. The multiple battery modules 4 can be arranged in any manner within the enclosure.

The battery cells provided in the embodiments of the present application may be metallic battery cells, for example, including negative electrode-free lithium metal battery cells, negative electrode-free sodium metal battery cells, and the like.

A negative electrode-free battery cell generally refers to a battery cell constructed without actively providing a negative electrode active material layer on the negative electrode side during the manufacturing process of the battery cell, for example, without forming a negative electrode active material layer by coating or depositing a layer or a carbonaceous active material layer at the negative electrode during the manufacturing process of the battery cell. During the first charge, ions gain electrons at the negative electrode side and deposit on the surface of the negative electrode current collector to form a metal, and during discharge, the metal can transform back into ions and return to the positive electrode, achieving cyclic charge and discharge. Compared to other battery cells, negative electrode-free battery cells can achieve higher energy density due to the absence of a negative electrode active material layer. The CB (Cell Balance) value of negative electrode-free battery cells is typically very small. For example, in some embodiments, the CB value of a negative electrode-free battery cell may be less than or equal to 0.1. The CB value is the ratio of the capacity per unit area of the negative electrode to the capacity per unit area of the positive electrode in a battery cell. Since negative electrode-free battery cells contain no or only a small amount of negative electrode active material, the capacity per unit area of the negative electrode is small, resulting in a low CB value, typically less than or equal to 0.1.

Embodiments of the present application provide a negative electrode current collector, where the negative electrode current collector includes a foam metal substrate, and the foam metal substrate has a mass-specific electrochemically active surface area of 2.5 cm²/g to 20 cm²/g and an electrochemically active volumetric surface area of 22 cm²/cm³ to 180 cm²/cm³.

Currently, the current collector commonly used for the negative electrode is a two-dimensional planar current collector, such as copper foil, with a relatively small mass-specific electrochemically active surface area of about 0.3 cm²/g. When a two-dimensional planar current collector is used in a metallic battery, the charging rate of the metallic battery is often limited. This is because at high charging current densities, metal deposition encounters problems, such as accelerated dendrite growth, increased side reactions, and more uneven metal deposition, thereby increasing the risk of internal short circuits in the battery, accelerating capacity decay, and the like.

The negative electrode current collector provided in the embodiments of the present application includes a foam metal substrate having a mass-specific electrochemically active surface area greater than or equal to 2.5 cm²/g and an electrochemically active volumetric surface area greater than or equal to 22 cm²/cm³. Therefore, compared to a two-dimensional planar copper foil current collector, the negative electrode current collector of the present application has a larger electrochemically active specific surface area. As a result, during battery charging, the negative electrode can have a higher electrochemically active area. This also allows for a decrease in the current density on the surface of the negative electrode and an improvement in the metal deposition morphology, thereby reducing the risk of internal short circuits in the battery and improving the reliability and cycle life of the battery. In addition, this enables the battery to undergo high-rate charging.

Meanwhile, the electrochemically active specific surface area of the foam metal substrate is not the larger the better. Generally, the foam metal substrate with a larger electrochemically active specific surface area has a higher content of small pores. Since metal deposition exhibits highly selective, it tends to preferentially occur in the pores on the side of the negative electrode close to the separator. In this case, if the electrochemically active specific surface area of the foam metal substrate is too large, the pores on the side of the negative electrode close to the separator may be quickly blocked by the deposited metal. Once the pores on the side of the negative electrode close to the separator are blocked, ions in the electrolyte solution are difficult or even unable to replenish to the internal positions of the negative electrode, thereby decreasing the space utilization of the negative electrode, and also leading to poor electrolyte solution wettability of the negative electrode, thereby deteriorating the cycling performance of the battery.

Therefore, by adjusting the mass-specific electrochemically active surface area of the foam metal substrate of the negative electrode current collector to 2.5 cm²/g to 20 cm²/g and the electrochemically active volumetric surface area to 22 cm²/cm³ to 180 cm²/cm³, embodiments of the present application can decrease the current density on the surface of the negative electrode, adjust the metal deposition morphology during charging, thereby mitigating dendrite growth, decreasing the risk of internal short circuits in the battery, improving the reliability and cycle life of the battery, and enabling the battery to undergo high-rate charging.

Optionally, the mass-specific electrochemically active surface area of the foam metal substrate may be 3.2 cm²/g to 10 cm²/g, and the electrochemically active volumetric surface area may be 29 cm²/cm³ to 90 cm²/cm³.

In some embodiments, the mass-specific electrochemically active surface area of the foam metal substrate may be 3.2 cm²/g to 5 cm²/g, and the electrochemically active volumetric surface area may be 29 cm²/cm³ to 45 cm²/cm³.

More active ions need to be consumed to activate the deposition sites on the surface of the negative electrode during the first charge of the battery as the electrochemically active specific surface area of the foam metal substrate increases, thereby decreasing the first-cycle coulombic efficiency of the battery. Accordingly, by further adjusting the mass-specific electrochemically active surface area and electrochemically active volumetric surface area of the foam metal substrate within the above ranges, the battery can achieve high coulombic efficiency while maintaining good cycling performance and rate performance.

The mass-specific electrochemically active surface area and electrochemically active volumetric surface area of the foam metal substrate can be tested as follows. The foam metal substrate is cut into small circular samples with a diameter of 20 mm and assembled into a coin cell with a metal lithium sheet as the counter electrode. The electrolyte salt of an electrolyte solution of the coin cell is LiFSI with a concentration of 1 mol/L, the solvent of the electrolyte solution is dimethoxyethane (DME), and the probe molecule is ferrocene with a concentration of 50 mmol/L. The separator of the coin cell may be a PE film with a thickness of 12 µm. At 25°C, the assembled coin cell is left to stand for 12 hours and discharged at a constant voltage of 2.5 V until the current drops to 0.0025 mA/cm², then cyclic voltammetry scans are performed within a range of 2.5 V to 3.4 V at scan rates of 3 mV/s, 2 mV/s, 1 mV/s, and 0.5 mV/s, and the peak current of the forward scan at each scan rate is read. A linear regression is conducted on the peak current and the square root of the scan rate to obtain the slope. The electrochemically active specific surface area of the foam metal substrate is calculated according to the Randles-Sevick equation. The test instrument may be a SOLARTRON electrochemical workstation from UK.

By adjusting the pore diameter, pore diameter distribution, porosity, number of pores, ligament width, or the like of the foam metal substrate, the electrochemically active specific surface area of the foam metal substrate can be adjusted.

In some embodiments, the foam metal substrate has an open-cell structure. Optionally, the open-cell rate can be greater than or equal to 98%.

In some embodiments, the number of pores having a pore diameter between 0.5 times an average pore diameter D_{avg} and 1.5 times the average pore diameter D_{avg} in the foam metal substrate may be 72% to 90% of a total number of pores in the foam metal substrate, optionally 80% to 90%.

In some embodiments, the number of pores having a pore diameter less than 0.5 times the average pore diameter D_{avg} in the foam metal substrate may be 4.5% to 15% of the total number of pores in the foam metal substrate, optionally 4.5% to 12%.

In some embodiments, the number of pores having a pore diameter greater than 1.5 times the average pore diameter D_{avg} in the foam metal substrate may be 2% to 15% of the total number of pores in the foam metal substrate, optionally 2% to 12%, 5% to 12%.

By adjusting the pore diameter distribution of the foam metal substrate within the above ranges, the foam metal substrate can have a higher electrochemically active specific surface area, thereby decreasing the current density on the surface of the negative electrode, adjusting the deposition morphology of the metal, improving the space utilization of the negative electrode, thereby helping to improve the coulombic efficiency, cycling performance, and rate performance of the battery; and the foam metal substrate and the negative electrode current collector can also have good electrolyte solution wettability, thereby enabling the battery to have a long cycle life.

In some embodiments, the number of pores having a pore diameter between 0.5 times the average pore diameter D_{avg} and 1.5 times the average pore diameter D_{avg} in the foam metal substrate may be 80% to 90% of the total number of surface pores in the foam metal substrate, the number of pores having a pore diameter less than 0.5 times the average pore diameter D_{avg} in the foam metal substrate may be 4.5% to 12% of the total number of surface pores in the foam metal substrate, and the number of pores having a pore diameter greater than 1.5 times the average pore diameter D_{avg} in the foam metal substrate may be 5% to 12% of the total number of surface pores in the foam metal substrate.

In some embodiments, the average pore diameter D_{avg} of the foam metal substrate may be 120 µm to 290 µm, optionally 180 µm to 290 µm, 200 µm to 290 µm, 230 µm to 290 µm, or 230 µm to 280 µm.

Under the same other conditions, a smaller average pore diameter of the foam metal substrate indicates a larger electrochemically active specific surface area of the foam metal substrate. Since metal deposition exhibits highly selective, it tends to preferentially occur in the pores on the side of the negative electrode close to the separator. In this case, as the average pore diameter of the foam metal substrate decreases, the pores on the side of the negative electrode close to the separator tend to be more quickly blocked by the deposited metal. Once the pores on the side of the negative electrode close to the separator are blocked, ions in the electrolyte solution are difficult or even unable to replenish to the internal positions of the negative electrode, thereby decreasing the space utilization of the negative electrode, and also leading to poor electrolyte solution wettability of the negative electrode.

By adjusting the average pore diameter of the foam metal substrate within the above range, the foam metal substrate can have a higher electrochemically active specific surface area. Moreover, the metal deposition morphology can be adjusted, and the space utilization of the negative electrode can be improved. This helps the battery to have both high coulombic efficiency and good cycling performance and rate performance.

In some embodiments, the maximum pore diameter Dₘₐₓ of the foam metal substrate may be 200 µm to 500 µm, 250 µm to 480 µm, 300 µm to 480 µm, 350 µm to 480 µm, 400 µm to 480 µm, or 420 µm to 480 µm.

The foam metal substrate is a porous material formed by interconnected ligaments, and its microstructure may be composed of ligaments and pores. In some embodiments, the ligament width of the foam metal substrate may be 5 µm to 100 µm, optionally 5 µm to 50 µm, more optionally 10 µm to 50 µm, 15 µm to 50 µm, 20 µm to 50 µm, or 25 µm to 50 µm.

During battery charging, metal may be deposited on the ligaments. When the average pore diameter of the foam metal substrate is the same, a larger ligament width can decrease the current density on the surface of the negative electrode. At low current densities, the nucleation diameter of metal deposition increases, and a larger nucleation diameter can mitigate dendrite growth and reduce repeated formation of the solid electrolyte interphase (SEI), thereby improving the coulombic efficiency, cycling performance, and rate performance of the battery. Moreover, the ligament width is not the larger the better, as excessively wide ligaments may occupy the volume available for metal deposition, thereby decreasing the energy density of the battery. In addition, in daily operating conditions of the battery, larger currents tend to be used to charge the battery, while excessively small currents usually cannot meet user needs.

Therefore, by adjusting the ligament width of the foam metal substrate within the above range, the battery can achieve both high coulombic efficiency and good cycling and rate performance.

The pore diameter, pore diameter distribution, and ligament width dimensions of the foam metal substrate can be tested as follows. Ten regions are randomly selected on the foam metal substrate, an optical microscope is used to observe the sample and take photos at 200× magnification, and the pore diameters and ligament widths of all surface pores on the surface of the foam metal substrate are measured and annotated. There are at least 20 surface pores in a photo corresponding to each region.

The pore diameter refers to the average diameter of a pore, and the average diameter refers to the arithmetic mean of the longest diameter and the shortest diameter of the pores.

The ligament width refers to the width of a ligament between adjacent pores.

The average of the pore diameters of all obtained surface pores is taken as the average pore diameter D_{avg} of the foam metal substrate.

The maximum value among the pore diameters of all obtained surface pores is taken as the maximum pore diameter Dₘₐₓ of the foam metal substrate.

The proportion of pores having a pore diameter between 0.5 times the average pore diameter D_{avg} and 1.5 times the average pore diameter D_{avg} is calculated by using the total number of all obtained surface pores as the denominator and the number of pores having a pore diameter between 0.5 times the average pore diameter D_{avg} and 1.5 times the average pore diameter D_{avg} as the numerator.

The proportion of pores having a pore diameter less than 0.5 times the average pore diameter D_{avg} is calculated by using the total number of all obtained surface pores as the denominator and the number of pores having a pore diameter less than 0.5 times the average pore diameter D_{avg} as the numerator.

The proportion of pores having a pore diameter greater than 1.5 times the average pore diameter D_{avg} is calculated by using the total number of all obtained surface pores as the denominator and the number of pores having a pore diameter greater than 1.5 times the average pore diameter D_{avg} as the numerator.

The average of the obtained ligament widths is taken as the ligament width of the foam metal substrate.

In some embodiments, the pore density of the foam metal substrate may be 135 PPI to 260 PPI, optionally 135 PPI to 200 PPI, 135 PPI to 180 PPI, or 150 PPI to 180 PPI. PPI, Pores Per Linear Inch, refers to the average number of pores per inch (that is, 2.54 cm).

The pore density of the foam metal substrate can be tested with reference to GB/T 20251-2006, for example, using an optical microscope with a magnification of 100×. During testing, 10 regions are randomly selected on the foam metal substrate, and the average of the test results is taken.

In some embodiments, the porosity of the foam metal substrate may be 65% to 91%, optionally 70% to 88%, 76% to 88%, 80% to 88%, or 82% to 88%.

The porosity of the foam metal substrate may be measured using the kerosene displacement method. The porosity P of the foam metal substrate = (V₀ - V)/V₀ × 100%. V₀ represents the volume of the foam metal substrate in its natural state (or apparent volume), V₀ = t × s. t represents the thickness of the foam metal substrate in cm; and s represents the area of the foam metal substrate in cm². V represents the absolute dense volume of the foam metal substrate, which can be measured using the kerosene displacement method.

In some embodiments, the thickness of the foam metal substrate may be 80 µm to 1000 µm, optionally 100 µm to 600 µm.

The thickness of the foam metal substrate can be measured by using a micrometer with an accuracy of 0.01 mm to measure 10 points and take the average.

When the foam metal substrate has a thickness within the above range, the ion diffusion path can be shortened, thereby improving the deposition and stripping activity and space utilization of the negative electrode.

In some embodiments, the metal elements present in the foam metal substrate may include one or more of copper, nickel, titanium, aluminum, cobalt, iron, manganese, tin, gold, silver, chromium, zinc, cadmium, lead, platinum, antimony, bismuth, gallium, indium, or palladium, optionally including one or more of copper or nickel.

In some embodiments, the negative electrode current collector may further include an alkali metal affinity layer located on a surface of the foam metal substrate. The alkali metal affinity layer can adjust the metal deposition morphology and mitigate dendrite growth, thereby improving the rate performance and cycling performance of the battery.

Optionally, the alkali metal affinity layer may include one or more of metal oxides, non-metal oxides, metal sulfides, non-metal sulfides, metal nitrides, or non-metal nitrides, optionally including one or more of Cu₂O or Li₃N.

Optionally, the thickness of the alkali metal affinity layer may be 50 nm to 5 µm, optionally 1 µm to 3 µm.

The foam metal substrate may be prepared by an electrodeposition method.

In some embodiments, the preparation method of the foam metal substrate includes the following steps: providing a foam polymer material; using the foam polymer material as a substrate to sequentially perform chemical deposition and electrodeposition to deposit metal material on the foam polymer material, then performing thermal reduction treatment to remove the foam polymer material and obtain a foam metal substrate.

Optionally, in some embodiments, the foam polymer material may include any one of polyurethane foam, melamine foam, expanded polyethylene (EPE), expanded polypropylene (EPP), expanded polystyrene (EPS), expandable polyethylene and styrene polymer (EPO), or chloroprene rubber foam (CR foam).

Optionally, in some embodiments, the porosity of the foam polymer material may be 65% to 95%, optionally 70% to 92%, 76% to 92%, 80% to 92%, or 82% to 92%.

Optionally, in some embodiments, the pore density of the foam polymer material may be 135 PPI to 260 PPI, optionally 135 PPI to 200 PPI.

Optionally, in some embodiments, the average pore diameter D_{avg} of the foam polymer material may be 120 µm to 400 µm, optionally 180 µm to 400 µm, 200 µm to 400 µm, 230 µm to 400 µm, or 230 µm to 400 µm.

Optionally, in some embodiments, the maximum pore diameter Dₘₐₓ of the foam polymer material may be 200 µm to 600 µm, optionally 250 µm to 600 µm, 300 µm to 600 µm, 350 µm to 600 µm, 400 µm to 600 µm, or 420 µm to 600 µm.

Optionally, in some embodiments, the number of pores having a pore diameter between 0.5 times the average pore diameter D_{avg} and 1.5 times the average pore diameter D_{avg} in the foam polymer material may be 72% to 90% of the total number of pores in the foam polymer material, optionally 80% to 90%; the number of pores having a pore diameter less than 0.5 times the average pore diameter D_{avg} in the foam polymer material may be 4.5% to 15% of the total number of pores in the foam polymer material, optionally 4.5% to 12%; and the number of pores having a pore diameter greater than 1.5 times the average pore diameter D_{avg} in the foam polymer material may be 2% to 15% of the total number of pores in the foam polymer material, optionally 2% to 12%.

Optionally, in some embodiments, the thickness of the foam polymer material may be 80 µm to 1000 µm, optionally 100 µm to 600 µm.

The test method for the foam polymer material may refer to the test method for the foam metal substrate described above.

The foam polymer material can be commercially available or prepared according to known preparation methods in the art. The foaming agent may be a physical foaming agent and/or a chemical foaming agent.

The physical foaming agent expands the polymer through a change in the physical state of the foaming agent. The physical foaming agent may include one or more of supercritical carbon dioxide, supercritical nitrogen, n-pentane, isopentane, n-butane, isobutane, n-hexane, n-heptane, cyclopentane, or propane.

The chemical foaming agent, also referred to as decomposable foaming agent, can expand the polymer by releasing gas through chemical reactions during the foaming process. The chemical foaming agent may include one or more of azo compounds, sulfonyl hydrazides, or nitroso compounds.

Optionally, prior to chemical deposition, the foam polymer material may undergo a pre-treatment process.

In some embodiments, the pretreatment may include steps of degreasing, roughening, sensitization, activation, and desmutting that are sequentially performed.

The roughening treatment can open blind pores in the foam polymer material, form numerous microscopic pits on the surface of the foam polymer material in which metal particles are deposit during chemical deposition, and generate hydrophilic groups on both inner and outer surfaces of the foam polymer material to facilitate subsequent treatments.

The purpose of sensitization treatment is to form a layer of easily oxidizable substance on the surface of the foam polymer material, which are oxidized during activation treatment while the activator is reduced to catalytic nuclei and remains on the surface of the foam polymer material.

The activation treatment involves immersing the sensitized foam polymer material in a solution containing catalytically active noble metal compounds for further treatment, generating a layer of catalytically active noble metal on the surface of the foam polymer material as a catalyst for the oxidation-reduction reaction of chemical deposition. The essence of activation is the reduction reaction of noble metals, and the reduced noble metal particles are generally gel-like with high surface activity and can be adsorbed on the surface of the foam polymer material.

The purpose of desmutting treatment is to remove the gel layer formed by activation treatment to fully expose noble metal atoms, thereby producing better catalytic effects in the chemical deposition stage.

Optionally, the roughening solution may be a sulfuric acid solution containing potassium permanganate.

Optionally, the sensitizing solution may be a hydrochloric acid solution containing stannous chloride.

Optionally, the activating solution may be a hydrochloric acid solution containing palladium chloride or an ammonia solution containing silver nitrate.

Optionally, the desmutting solution may be a formaldehyde solution or a hydrochloric acid solution.

The foam polymer material is an insulating material and cannot be directly electrodeposited with metal. The purpose of chemical deposition is to coat the foam polymer material with a thin metal film so as to render the foam polymer material conductive, thereby enabling the electrodeposited coating more uniform in structure and smoother on the surface.

Plating bath formulations known in the art may be used in chemical deposition. Taking chemical copper deposition as an example, the plating bath may include: copper sulfate, formaldehyde, potassium sodium tartrate, sodium hydroxide, and the like.

To further reduce costs, the metal from chemical deposition may be different from the metal from electrodeposition, for example, may be a less expensive base metal. Taking electrodeposited copper as an example, the metal from chemical deposition may be nickel, which is less costly.

Plating bath formulations known in the art may be used in electrodeposition. Taking electrodeposited copper as an example, the plating bath may include: copper sulfate, sulfuric acid, potassium chloride, polyethylene glycol, and the like.

By adjusting the process parameters of electrodeposition, such as deposition time, voltage, and current density, the deposition amount of metal can be adjusted, thereby adjusting the areal density of the foam metal substrate.

The purpose of thermal reduction treatment is to remove the foam polymer material.

Optionally, the thermal reduction gas for thermal reduction treatment may be a mixture of hydrogen and argon or a mixture of hydrogen and nitrogen.

Optionally, the temperature for thermal reduction treatment may be 650°C to 850°C.

### [Positive electrode plate]

The battery cell includes a positive electrode plate.

In some embodiments, the positive electrode plate includes a positive electrode current collector and a positive electrode film layer disposed on at least one surface of the positive electrode current collector and including a positive electrode active material. For example, the positive electrode current collector has two surfaces opposite in its thickness direction, and the positive electrode film layer is disposed on either or both of the two opposite surfaces of the positive electrode current collector.

In some embodiments, the positive electrode active material includes materials capable of deintercalating and intercalating lithium.

In an example, the positive electrode active material may include, but is not limited to, one or more of lithium transition metal oxides, metal chalcogenides, lithium-containing phosphates, or modified compounds thereof. Examples of lithium transition metal oxides may include, but are not limited to, one or more of lithium cobalt oxide, lithium nickel oxide, lithium manganese oxide, lithium nickel cobalt oxide, lithium manganese cobalt oxide, lithium nickel manganese oxide, lithium nickel cobalt manganese oxide, lithium nickel cobalt aluminum oxide, lithium titanium oxide, or modified compounds thereof. Lithium transition metal oxides may include, but are not limited to, laminar structures or spinel structures. Examples of lithium-containing phosphates may include, but are not limited to, one or more of lithium iron phosphate, a composite material of lithium iron phosphate and carbon, lithium manganese phosphate, a composite material of lithium manganese phosphate and carbon, lithium manganese iron phosphate, a composite material of lithium manganese iron phosphate and carbon, and one or more modified compounds thereof.

In some embodiments, to further enhance the energy density of the battery, the positive electrode active material may include one or more of lithium transition metal oxides represented by the general formula LiₐNi_{b}Co_{c}M_{d}OₑD_{f} or their modified compounds, where 0.8 ≤ a ≤ 1.2, 0.5 ≤ b < 1, 0 < c < 1, 0 < d < 1, 1 ≤ e ≤ 2, 0 ≤ f ≤ 1, M may include, but is not limited to, one or more of Ge, Mo, Sn, Mn, Al, Zr, Zn, Cu, Cr, Mg, Fe, V, Ti, or B, and D may include, but is not limited to, one or more of N, F, S, or Cl.

In some embodiments, the positive electrode active material may include both lithium transition metal oxides and lithium-containing phosphates. This configuration facilitates obtaining a battery that offers both high capacity and high reliability.

In an example, the positive electrode active material may include, but is not limited to, one or more of LiCoO₂, LiNiO₂, LiMnO₂, LiNi_{1/2}Mn_{1/2}O₂, LiMn₂O₄, Li_{4/3}Ti_{5/3}O₄, LiNi_{1/2}Mn_{1/2}O₂, LiNi_{1/3}Co_{1/3}Mn_{1/3}O₂ (NCM333), LiNi_{0.5}Co_{0.2}Mn_{0.3}O₂ (NCM523), LiNi_{0.6}Co_{0.2}Mn_{0.2}O₂ (NCM622), LiNi_{0.8}Co_{0.1}Mn_{0.1}O₂ (NCM811), LiNi_{0.80}Co_{0.15}Al_{0.05}O₂, LiFePO₄, LiMnPO₄, or Li1.13Ti0.57Fe0.3S2.

During the charge and discharge process of the battery cell, the deintercalation and consumption of Li occur, and the molar content of Li varies when the battery cell is discharged to different states. In the listing of positive electrode active materials in the present application, the molar content of Li is the initial state of the material, that is, the state before feeding. When the positive electrode active material is applied in a battery cell, the molar content of Li may change after charge and discharge cycles. In the listing of positive electrode active materials in the present application, the molar content of O is only a theoretical value, and lattice oxygen release may cause variations in the molar content of O, with the actual molar content of O subject to fluctuation.

In some embodiments, the positive electrode active material includes materials capable of deintercalating and intercalating sodium. For example, the positive electrode active material may include, but is not limited to, one or more of laminar transition metal oxides (including but not limited to P2-type or O3-type), polyanionic materials (such as phosphates, fluorophosphates, pyrophosphates, and sulfates), or Prussian-type materials.

In some embodiments, in an example, the positive electrode active material may include, but is not limited to, one or more of NaFeO₂, NaCoO₂, NaCrO₂, NaMnO₂, NaNiO₂, Na_{0.67}MO₂ (where M includes at least two of Fe, Co, Cr, Mn, Ni, V, Ti, or Mo), NaMO₂ (where M includes at least two of Fe, Co, Ni, V, Ti, or Mo), NaFePO₄, NaMnPO₄, NaCoPO₄, Na₄Fe₃(PO₄)₂O₇, Na₃V₂(PO₄)₂F₃, Na₃V₂(PO₄)₃, Prussian blue, Prussian white, or modified compounds thereof.

The modified compounds of the above positive electrode active materials may involve doping modification and/or surface coating modification of the positive electrode active materials.

In some embodiments, the positive electrode film layer may optionally further include a positive electrode conductive agent. In an example, the positive electrode conductive agent may include, but is not limited to, one or more of superconducting carbon, conductive graphite, acetylene black, carbon black, Ketjen black, carbon dots, carbon nanotubes, graphene, or carbon nanofibers.

In some embodiments, the positive electrode film layer may optionally further include a positive electrode binder. In an example, the positive electrode binder may include, but is not limited to, one or more of polyvinylidene fluoride (PVDF), polytetrafluoroethylene (PTFE), vinylidene fluoride-tetrafluoroethylene-propylene terpolymer, vinylidene fluoride-hexafluoropropylene-tetrafluoroethylene terpolymer, tetrafluoroethylene-hexafluoropropylene copolymer, polyethylene oxide, fluorinated acrylate resin, styrene-butadiene rubber (SBR), water-soluble unsaturated resin SR-1B, water-based acrylic resin (for example, polyacrylic acid PAA, polymethacrylic acid PMAA, sodium polyacrylate PAAS), polyacrylamide (PAM), polyvinyl alcohol (PVA), sodium alginate (SA), or carboxymethyl chitosan (CMCS).

In some embodiments, the positive electrode current collector may be a metal foil or a composite current collector. As an example of a metal foil, aluminum foil may be used. The composite current collector may include a polymer material base layer and a metallic material layer formed on at least one surface of the polymer material base layer. In an example, the metallic material may include, but is not limited to, one or more of aluminum, aluminum alloy, nickel, nickel alloy, titanium, titanium alloy, silver, or silver alloy. In an example, the polymer material base layer may include, but is not limited to, one or more of polypropylene, polyethylene terephthalate (PET), polybutylene terephthalate (PBT), polystyrene (PS), or polyethylene (PE).

The positive electrode film layer is typically formed by coating a positive electrode slurry on the positive electrode current collector, followed by drying and cold pressing. The positive electrode slurry is generally formed by dispersing the positive electrode active material, an optional positive electrode conductive agent, an optional positive electrode binder, and any other components in a solvent and stirring them until the mixture is uniform. The solvent may be N-methylpyrrolidone (NMP), but is not limited thereto.

### [Electrolyte]

The battery cell includes an electrolyte.

In some embodiments, the electrolyte is an electrolyte solution, which includes an electrolyte salt and an organic solvent.

In some embodiments, the electrolyte solution includes anions, which may include one or more of bis(fluorosulfonyl)imide anion (FSI⁻), bis(trifluoromethanesulfonyl)imide anion (TFSI⁻), bis(oxalato)borate anion (BOB⁻), difluoro(oxalato)borate anion (DFOB⁻), difluorobis(oxalato)phosphate anion (DFOP⁻), tetrafluoro(oxalato)phosphate anion (TFOP⁻), difluorophosphate anion (PO₂F₂⁻), hexafluorophosphate anion (PF₆⁻), tetrafluoroborate anion (BF₄⁻), hexafluoroarsenate anion (AsF₆⁻), or trifluoromethanesulfonate anion (CF₃SO₃⁻).

In some embodiments, the electrolyte solution includes cations, which may include one or more of lithium ions or sodium ions.

In some embodiments, a concentration of the electrolyte salt may be 0.3 mol/L or higher, optionally 0.7 mol/L or higher. Further, the concentration of the electrolyte salt may be 4 mol/L or lower, optionally 2.5 mol/L or lower, or 1.7 mol/L or lower. The electrolyte salt having a concentration within the above range enables the electrolyte solution to have appropriate ionic conductivity.

The organic solvent may include, but is not limited to, one or more of esters, ethers, sulfones, or nitriles. Esters may include, but are not limited to, one or more of carbonates, phosphates, carboxylates, sulfates, or sulfonates. Carbonates may include cyclic carbonates and/or linear carbonates, optionally including both cyclic carbonates and linear carbonates. Linear carbonates may include low-viscosity polar linear carbonates, aliphatic branched carbonates, and the like.

In an example, the organic solvent may include, but is not limited to, one or more of ethylene carbonate (EC), propylene carbonate (PC), butylene carbonate, ethyl methyl carbonate (EMC), diethyl carbonate (DEC), dimethyl carbonate (DMC), dipropyl carbonate (DPC), methyl propyl carbonate (MPC), ethyl propyl carbonate (EPC), butylene carbonate (BC), fluoroethylene carbonate (FEC), methyl formate (MF), methyl acetate (MA), ethyl acetate (EA), propyl acetate (PA), methyl propionate (MP), ethyl propionate (EP), propyl propionate (PP), methyl butyrate (MB), ethyl butyrate (EB), 1,4-butyrolactone (GBL), sulfolane (SF), dimethyl sulfone (MSM), methyl ethyl sulfone (EMS), diethyl sulfone (ESE), tetraethylene glycol dimethyl ether (TEGDME), dimethoxyethane (DME), 1,3-dioxolane (DOL), trimethyl phosphate, 3-methoxypropionitrile, H(CF₂)₂OCH₃, C₄F₉OCH₃, H(CF₂)₂OCH₂CH₃, H(CF₂)₂OCH₂CF₃, H(CF₂)₂CH₂O(CF₂)₂H, CF₃CHFCF₂OCH₃, CF₃CHFCF₂OCH₂CH₃, 2-trifluoromethyl hexafluoropropyl methyl ether, 2-trifluoromethyl hexafluoropropyl ethyl ether, 2-trifluoromethyl hexafluoropropyl propyl ether, 3-trifluoromethyl octafluorobutyl methyl ether, 3-trifluoromethyl octafluorobutyl ethyl ether, 3-trifluoromethyl octafluorobutyl propyl ether, 4-trifluoromethyl decafluoropentyl methyl ether, 4-trifluoromethyl decafluoropentyl ethyl ether, 4-trifluoromethyl decafluoropentyl propyl ether, 5-trifluoromethyl dodecafluorohexyl methyl ether, 5-trifluoromethyl dodecafluorohexyl ethyl ether, 5-trifluoromethyl dodecafluorohexyl propyl ether, 6-trifluoromethyl tetradecafluoroheptyl methyl ether, 6-trifluoromethyl tetradecafluoroheptyl ethyl ether, 6-trifluoromethyl tetradecafluoroheptyl propyl ether, 7-trifluoromethyl hexadecafluorooctyl methyl ether, 7-trifluoromethyl hexadecafluorooctyl ethyl ether, or 7-trifluoromethyl hexadecafluorooctyl propyl ether.

In some embodiments, the electrolyte solution may optionally further include additives. For example, the additives may include a negative electrode film-forming additives, a positive electrode film-forming additives, or an additive capable of improving certain properties of batteries, such as an additive for improving overcharge performance of batteries, an additive for improving high-temperature performance of batteries, or an additive for improving low-temperature power performance of batteries.

### [Separator]

The battery cell may further include a separator. The separator is located between the positive electrode and the negative electrode, primarily to prevent internal short circuits.

The present application does not impose specific restrictions on the type of separator, and any well-known porous structure separator with good chemical and mechanical stability can be used.

In some embodiments, the material of the separator may include, but is not limited to, one or more of glass fiber, non-woven fabric, polyethylene, polypropylene, or polyvinylidene fluoride. The separator may be a single-layer film or a multilayer composite film. When the separator is a multilayer composite film, the materials of each layer may be the same or different.

The preparation method for the battery cell is well-known. In some embodiments, the positive electrode, separator, negative electrode, and electrolyte solution can be assembled to form a battery cell. In an example, the positive electrode, separator, and negative electrode may be made into an electrode assembly through a winding process and/or a lamination process; and the electrode assembly is placed in an outer package, followed by drying, and the above electrolyte solution is injected, followed by processes such as vacuum encapsulation, standing, and formation to obtain a battery cell. Multiple battery cells can be further connected in series, parallel, or a combination thereof to form a battery module. Multiple battery modules can be further connected in series, parallel, or a combination thereof to form a battery pack. In some embodiments, multiple battery cells may alternatively be directly assembled into a battery pack.

Embodiments of the present application further provide an electric apparatus including the battery provided in the embodiments of the present application. The battery may be used as a power source for the electric apparatus or as an energy storage unit for the electric apparatus. The electric apparatus may include, but is not limited to, a mobile device (for example, a mobile phone, a tablet computer, or a notebook computer), an electric vehicle (for example, a full electric vehicle, a hybrid electric vehicle, a plug-in hybrid electric vehicle, an electric bicycle, an electric scooter, an electric golf vehicle, or an electric truck), an electric train, a ship, a satellite, or an energy storage system.

The type of battery, such as a battery cell, battery module, or battery pack, may be selected depending on usage requirements of the electric apparatus.

FIG. 6 is a schematic diagram of an electric apparatus as an example. The electric apparatus is a pure electric vehicle, a hybrid electric vehicle, a plug-in hybrid electric vehicle, or the like. To meet the high power and high energy density requirements of the electric apparatus, a battery pack or battery module can be used.

In another example, the electric apparatus may be a mobile phone, tablet computer, laptop, or the like. Such electric apparatuses typically required to be light and thin, and a battery cell may be used as a power source.

### Examples

The following examples describe the content disclosed in the present application in more detail, and these examples are provided only for illustrative purposes, as various modifications and changes within the scope of the disclosure of the present application will be apparent to those skilled in the art. Unless otherwise stated, all parts, percentages, and ratios reported in the following examples are based on weight, all reagents used in the examples are commercially available or synthesized by conventional methods and can be used directly without further processing, and all instruments used in the examples are commercially available.

### Example 1

Commercially available polyurethane foam was used as a substrate, then successively subjected to degreasing, roughening, sensitization, activation, desmutting, chemical deposition, electrodeposition, and thermal reduction treatment to obtain a foam metal substrate.

The polyurethane foam had a thickness of 120 µm, a pore density of 135 PPI, a porosity of 80% to 95%, an average pore diameter of about 290 µm, a maximum pore diameter of about 480 µm, the proportion of pores having a pore diameter between 0.5 times the average pore diameter D_{avg} and 1.5 times the average pore diameter D_{avg} in the polyurethane foam was about 83.3%, the proportion of pores having a pore diameter less than 0.5 times the average pore diameter D_{avg} was about 5.7%, and the proportion of pores having a pore diameter greater than 1.5 times the average pore diameter D_{avg} was about 11.0%.

### (1) Degreasing

The polyurethane foam was placed in a degreasing solution at 40°C for 10 min, then rinsed with deionized water and squeezed dry.

The degreasing solution contained 30 g/L sodium carbonate, 30 g/L sodium phosphate, and 15 g/L sodium dodecyl sulfate, with water as the solvent.

### (2) Roughening

The degreased polyurethane foam was immersed in a roughening solution at 35°C for 5 min, then rinsed with deionized water and squeezed dry.

The roughening solution contained 13 g/L potassium permanganate, and 7 mL/L concentrated sulfuric acid, with water as the solvent.

### (3) Sensitization

The roughened polyurethane foam was immersed in a roughening solution at 25°C for 5 min.

The sensitizing solution contained 20 g/L stannous chloride and 40 mL/L hydrochloric acid (36% by mass), with tin particles added thereto.

### (4) Activation

The sensitized polyurethane foam was rinsed with deionized water and immersed in an activating solution at 25°C for 5 min.

The activating solution contained 3 g/L silver nitrate and 5 mL/L ammonia (25% by mass), with water as the solvent.

### (5) Desmutting

The activated polyurethane foam was immersed in a 14% hydrochloric acid aqueous solution for 2 min.

### (6) Chemical deposition

The desmutted polyurethane foam was placed in a chemical plating bath at 60°C for 5 min.

The chemical plating bath contained 10 g/L copper sulfate, 20 mL/L formaldehyde, 3 g/L potassium sodium tartrate, 40 g/L EDTA, and 10 g/L sodium hydroxide, with water as the solvent.

### (7) Electrodeposition

An electrolytic cell was set up using a direct-current power supply apparatus. The polyurethane foam after chemical deposition was thoroughly rinsed with deionized water, then immersed in the electrode plating bath as the cathode, with a copper sheet as the anode, to perform electrochemical plating. The amount of copper deposited by electrochemical plating was about 230 g/cm².

The electrode plating bath contained 70 g/L copper sulfate, 25 mL/L sulfuric acid, 0.6 mL/L potassium chloride, and 0.003 g/L polyethylene glycol, with water as the solvent.

### (8) Thermal reduction

The polyurethane foam after electrochemical plating was thoroughly rinsed with deionized water and anhydrous ethanol, then placed in a tube furnace. The tube furnace was evacuated to a pressure below 100 Pa, followed by introduction of a hydrogen-argon mixture with 10% hydrogen volume until the internal pressure in the furnace tube reached atmospheric pressure. The outlet valve was opened to maintain the internal pressure in the furnace tube at atmospheric pressure. The heating rate was set to 5°C/min, and the temperature was raised to 700°C, held for 2 hours, and then allowed to be cooled naturally, and a foam metal substrate with the polyurethane foam removed was obtained and taken from the furnace, that is, copper foam.

### Example 2

The preparation method of the foam metal substrate was similar to Example 1, except that the polyurethane foam substrate parameters were different.

The polyurethane foam had a thickness of 120 µm, a pore density of 150 PPI, a porosity of 80% to 95%, an average pore diameter of about 280 µm, a maximum pore diameter of about 480 µm, the proportion of pores having a pore diameter between 0.5 times the average pore diameter D_{avg} and 1.5 times the average pore diameter D_{avg} in the polyurethane foam was about 83.9%, the proportion of pores having a pore diameter less than 0.5 times the average pore diameter D_{avg} was about 4.7%, and the proportion of pores having a pore diameter greater than 1.5 times the average pore diameter D_{avg} was about 11.4%.

### Example 3

The preparation method of the foam metal substrate was similar to Example 1, except that the polyurethane foam substrate parameters were different.

The polyurethane foam had a thickness of 120 µm, a pore density of 160 PPI, a porosity of 80% to 95%, an average pore diameter of about 270 µm, a maximum pore diameter of about 470 µm, the proportion of pores having a pore diameter between 0.5 times the average pore diameter D_{avg} and 1.5 times the average pore diameter D_{avg} in the polyurethane foam was about 81.3%, the proportion of pores having a pore diameter less than 0.5 times the average pore diameter D_{avg} was about 10.3%, and the proportion of pores having a pore diameter greater than 1.5 times the average pore diameter D_{avg} was about 8.4%.

### Example 4

The preparation method of the foam metal substrate was similar to Example 1, except that the polyurethane foam substrate parameters were different.

The polyurethane foam had a thickness of 120 µm, a pore density of 170 PPI, a porosity of 80% to 95%, an average pore diameter of about 260 µm, a maximum pore diameter of about 470 µm, the proportion of pores having a pore diameter between 0.5 times the average pore diameter D_{avg} and 1.5 times the average pore diameter D_{avg} in the polyurethane foam was about 81.5%, the proportion of pores having a pore diameter less than 0.5 times the average pore diameter D_{avg} was about 11.1%, and the proportion of pores having a pore diameter greater than 1.5 times the average pore diameter D_{avg} was about 7.4%.

### Example 5

The preparation method of the foam metal substrate was similar to Example 1, except that the polyurethane foam substrate parameters were different.

The polyurethane foam had a thickness of 120 µm, a pore density of 180 PPI, a porosity of 80% to 95%, an average pore diameter of about 250 µm, a maximum pore diameter of about 450 µm, the proportion of pores having a pore diameter between 0.5 times the average pore diameter D_{avg} and 1.5 times the average pore diameter D_{avg} in the polyurethane foam was about 82.0%, the proportion of pores having a pore diameter less than 0.5 times the average pore diameter D_{avg} was about 11.5%, and the proportion of pores having a pore diameter greater than 1.5 times the average pore diameter D_{avg} was about 6.5%.

### Example 6

The preparation method of the foam metal substrate was similar to Example 1, except that the polyurethane foam substrate parameters were different.

The polyurethane foam had a thickness of 120 µm, a pore density of 190 PPI, a porosity of 80% to 95%, an average pore diameter of about 240 µm, a maximum pore diameter of about 430 µm, the proportion of pores having a pore diameter between 0.5 times the average pore diameter D_{avg} and 1.5 times the average pore diameter D_{avg} in the polyurethane foam was about 83.5%, the proportion of pores having a pore diameter less than 0.5 times the average pore diameter D_{avg} was about 11.9%, and the proportion of pores having a pore diameter greater than 1.5 times the average pore diameter D_{avg} was about 4.6%.

### Example 7

The preparation method of the foam metal substrate was similar to Example 1, except that the polyurethane foam substrate parameters were different.

The polyurethane foam had a thickness of 120 µm, a pore density of 200 PPI, a porosity of 80% to 95%, an average pore diameter of about 230 µm, a maximum pore diameter of about 420 µm, the proportion of pores having a pore diameter between 0.5 times the average pore diameter D_{avg} and 1.5 times the average pore diameter D_{avg} in the polyurethane foam was about 85.8%, the proportion of pores having a pore diameter less than 0.5 times the average pore diameter D_{avg} was about 11.9%, and the proportion of pores having a pore diameter greater than 1.5 times the average pore diameter D_{avg} was about 2.3%.

### Example 8

The preparation method of the foam metal substrate was similar to Example 1, except that the polyurethane foam substrate parameters were different.

The polyurethane foam had a thickness of 120 µm, a pore density of 240 PPI, a porosity of 80% to 95%, an average pore diameter of about 160 µm, a maximum pore diameter of about 300 µm, the proportion of pores having a pore diameter between 0.5 times the average pore diameter D_{avg} and 1.5 times the average pore diameter D_{avg} in the polyurethane foam was about 73.2%, the proportion of pores having a pore diameter less than 0.5 times the average pore diameter D_{avg} was about 12.3%, and the proportion of pores having a pore diameter greater than 1.5 times the average pore diameter D_{avg} was about 14.5%.

### Example 9

The preparation method of the foam metal substrate was similar to Example 1, except that the polyurethane foam substrate parameters were different.

The polyurethane foam had a thickness of 120 µm, a pore density of 250 PPI, a porosity of 80% to 95%, an average pore diameter of about 140 µm, a maximum pore diameter of about 260 µm, the proportion of pores having a pore diameter between 0.5 times the average pore diameter D_{avg} and 1.5 times the average pore diameter D_{avg} in the polyurethane foam was about 72.6%, the proportion of pores having a pore diameter less than 0.5 times the average pore diameter D_{avg} was about 13.9%, and the proportion of pores having a pore diameter greater than 1.5 times the average pore diameter D_{avg} was about 13.5%.

### Example 10

The preparation method of the foam metal substrate was similar to Example 1, except that the polyurethane foam substrate parameters were different.

The polyurethane foam had a thickness of 120 µm, a pore density of 260 PPI, a porosity of 80% to 95%, an average pore diameter of about 120 µm, a maximum pore diameter of about 250 µm, the proportion of pores having a pore diameter between 0.5 times the average pore diameter D_{avg} and 1.5 times the average pore diameter D_{avg} in the polyurethane foam was about 72.4%, the proportion of pores having a pore diameter less than 0.5 times the average pore diameter D_{avg} was about 14.7%, and the proportion of pores having a pore diameter greater than 1.5 times the average pore diameter D_{avg} was about 12.9%.

### Comparative Example 1

The preparation method of the foam metal substrate was similar to Example 1, except that the polyurethane foam substrate parameters were different.

The polyurethane foam had a thickness of 120 µm, a pore density of 120 PPI, a porosity of 80% to 95%, an average pore diameter of about 300 µm, a maximum pore diameter of about 500 µm, the proportion of pores having a pore diameter between 0.5 times the average pore diameter D_{avg} and 1.5 times the average pore diameter D_{avg} in the polyurethane foam was about 66.2%, the proportion of pores having a pore diameter less than 0.5 times the average pore diameter D_{avg} was about 1.9%, and the proportion of pores having a pore diameter greater than 1.5 times the average pore diameter D_{avg} was about 31.9%.

### Comparative Example 2

The preparation method of the foam metal substrate was similar to Example 1, except that the polyurethane foam substrate parameters were different.

The polyurethane foam had a thickness of 120 µm, a pore density of 270 PPI, a porosity of 80% to 95%, an average pore diameter of about 100 µm, a maximum pore diameter of about 250 µm, the proportion of pores having a pore diameter between 0.5 times the average pore diameter D_{avg} and 1.5 times the average pore diameter D_{avg} in the polyurethane foam was about 70.9%, the proportion of pores having a pore diameter less than 0.5 times the average pore diameter D_{avg} was about 16.7%, and the proportion of pores having a pore diameter greater than 1.5 times the average pore diameter D_{avg} was about 12.4%.

### Performance testing of polyurethane foam and foam metal substrate

### (1) Pore diameter, pore diameter distribution, and ligament width testing of polyurethane foam and foam metal substrate

Ten regions were randomly selected on the foam metal substrate, an optical microscope was used to observe the sample and take photos at 200× magnification, and the pore diameters and ligament widths of all surface pores on the surface of the foam metal substrate were measured and annotated. There were at least 20 surface pores in a photo corresponding to each region.

The pore diameter refers to the average diameter of a pore, and the average diameter refers to the arithmetic mean of the longest diameter and the shortest diameter of the pore.

The ligament width refers to the width of a ligament between adjacent pores.

The average of the pore diameters of all obtained surface pores was taken as the average pore diameter D_{avg} of the foam metal substrate.

The maximum value among the pore diameters of all obtained surface pores was taken as the maximum pore diameter Dₘₐₓ of the foam metal substrate.

The proportion of pores having a pore diameter between 0.5 times the average pore diameter D_{avg} and 1.5 times the average pore diameter D_{avg} was calculated by using the total number of all obtained surface pores as the denominator and the number of pores having a pore diameter between 0.5 times the average pore diameter D_{avg} and 1.5 times the average pore diameter D_{avg} as the numerator.

The proportion of pores having a pore diameter less than 0.5 times the average pore diameter D_{avg} was calculated by using the total number of all obtained surface pores as the denominator and the number of pores having a pore diameter less than 0.5 times the average pore diameter D_{avg} as the numerator.

The proportion of pores having a pore diameter greater than 1.5 times the average pore diameter D_{avg} was calculated by using the total number of all obtained surface pores as the denominator and the number of pores having a pore diameter greater than 1.5 times the average pore diameter D_{avg} as the numerator.

The average of the obtained ligament widths was taken as the ligament width of the foam metal substrate.

The test method for the polyurethane foam was the same as that for the foam metal substrate.

### (2) Pore density testing of polyurethane foam and foam metal substrate

The test was performed with reference to GB/T 20251-2006. The average number of surface pores per inch (that is, 2.54 cm) was used as the pore density.

An optical microscope with a magnification of 100× was used to check the number of pores in polyurethane foam and foam metal substrate. During testing, 10 regions were randomly selected on the polyurethane foam and foam metal substrate, and the average of the test results was taken.

### (3) Porosity testing of polyurethane foam and foam metal substrate

The porosity was measured using the kerosene displacement method.

The volume of the foam metal substrate in its natural state (or apparent volume) V₀ = t × s. t represents the thickness of the foam metal substrate in cm; and s represents the area of the foam metal substrate in cm². Measurement of foam metal substrate thickness: A micrometer with an accuracy of 0.01 mm was used to measure the thickness t of the foam metal substrate, 10 points were measured and the average was taken. Measurement of foam metal substrate area: A coordinate paper was placed on a flat transparent glass, a white planar light source was placed under the glass, then the foam metal substrate to be measured was placed on the coordinate paper; a projected area of the foam metal substrate on the coordinate paper was read, and the sample was measured twice and the average was taken and denoted as s, where the difference between the two measurements should not exceed 1%.

The absolute dense volume V of the foam metal substrate was measured as follows.

A calibrated graduated cylinder was taken, cleaned, and dried. Four hours prior to testing, the graduated cylinder, a dropper, kerosene, and a foam metal substrate sample to be tested were placed in a calibration laboratory with the temperature controlled at 20 ± 5 °C and temperature variations not exceeding 1 °C/h. For the test, the foam metal substrate was first placed into the graduated cylinder, then the graduated cylinder was placed on a balance and tared. Subsequently, kerosene was dripped into the graduated cylinder using the dropper. After the meniscus of the kerosene level submerged the foam metal substrate, kerosene was added dropwise to accurately adjust the liquid level to a specific graduation mark on the graduated cylinder, then the reading V₁ (in mL) on the cylinder and the weight m₃ (unit g) displayed by the balance at this point were recorded. The absolute dense volume V of the foam metal substrate was calculated as: V = (V₁ × ε) - (m₃/ρ), where ε is the correction coefficient of the graduated cylinder; and ρ is the density of kerosene in g/cm³.

The porosity of the foam metal substrate was calculated as: P = (V₀ - V)/V₀ × 100%.

The test method for the polyurethane foam is the same as that for foam metal substrate.

### (4) Electrochemically active specific surface area testing of foam metal substrate

The prepared foam metal substrate was cut into small circular samples with a diameter of 20 mm and assembled into a coin cell with a metal lithium sheet as the counter electrode. The electrolyte salt of the electrolyte solution of the coin cell was LiFSI with a concentration of 1 mol/L, the solvent of the electrolyte solution was dimethoxyethane (DME), and the probe molecule was ferrocene with a concentration of 50 mmol/L. The separator of the coin cell may be a PE film with a thickness of 12 µm.

At 25°C, the assembled coin cell was left to stand for 12 hour and discharged at a constant voltage of 2.5 V until the current dropped to 0.0025 mA/cm², then cyclic voltammetry scans were performed within the range of 2.5 V to 3.4 V at scan rates of 3 mV/s, 2 mV/s, 1 mV/s, and 0.5 mV/s, and the peak current of the positive scan at each scan rate was read. A linear regression was conducted on the peak current and the square root of the scan rate to obtain the slope. The electrochemically active specific surface area of the foam metal substrate was calculated according to the Randles-Sevick equation. The test instrument was a SOLARTRON electrochemical workstation from UK.

**Table 1**

| No. | Foam metal substrate parameters | | | | | | | | | | |
|---|---|---|---|---|---|---|---|---|---|---|---|
| | Thickness (µm) | PPI | Porosity | Ligament width (µm) | Averag e pore diamet er D_{avg} (µm) | Maximu m pore diameter Dₘₐₓ (µm) | Pore diameter distribution | | | Mass-specific electrochemically active surface area (cm²/g) | Electrochemically active volumetric surface area (cm²/cm³) |
| | | | | | | | Proportion of pores having a pore diameter less than 0.5×D_{avg} | Proportion of pores having a pore diameter between 0.5×D_{avg} and 1.5×D_{avg} | Proportion of pores having a pore diameter greater than 1.5×D_{avg} | | |
| Comparative Example 1 | 120 | 120 | 91.3% | 50 | 300 | 500 | 1.9% | 66.2% | 31.9% | 2.35 | 21.09 |
| Comparative Example 2 | 120 | 270 | 80.5% | 5 | 100 | 250 | 16.7% | 70.9% | 12.4% | 22.00 | 197.12 |
| Example 1 | 120 | 135 | 90.7% | 50 | 290 | 480 | 5.7% | 83.3% | 11.0% | 2.54 | 22.72 |
| Example 2 | 120 | 150 | 87.5% | 50 | 280 | 480 | 4.7% | 83.9% | 11.4% | 3.27 | 29.31 |
| Example 3 | 120 | 160 | 86.4% | 50 | 270 | 470 | 10.3% | 81.3% | 8.4% | 3.70 | 33.19 |
| Example 4 | 120 | 170 | 84.3% | 50 | 260 | 470 | 11.1% | 81.5% | 7.4% | 3.86 | 34.60 |
| Example 5 | 120 | 180 | 82.6% | 50 | 250 | 450 | 11.5% | 82.0% | 6.5% | 4.49 | 40.27 |
| Example 6 | 120 | 190 | 81.7% | 50 | 240 | 430 | 11.9% | 83.5% | 4.6% | 6.56 | 58.76 |
| Example 7 | 120 | 200 | 80.2% | 50 | 230 | 420 | 11.9% | 85.8% | 2.3% | 7.56 | 67.76 |
| Example 8 | 120 | 240 | 83.1% | 5 | 160 | 300 | 12.3% | 73.2% | 14.5% | 10.10 | 90.51 |
| Example 9 | 120 | 250 | 82.6% | 5 | 140 | 260 | 13.9% | 72.6% | 13.5% | 15.59 | 139.66 |
| Example 10 | 120 | 260 | 81.7% | 5 | 120 | 250 | 14.7% | 72.4% | 12.9% | 20.00 | 179.20 |

Next, the prepared foam metal substrate was directly used as the negative electrode current collector to assemble into a battery, and the following performance tests were performed.

Battery preparation: Lithium iron phosphate, conductive agent carbon black (Super P), and binder polyvinylidene fluoride (PVDF) were mixed uniformly in a weight ratio of 8:1:1 in an appropriate amount of solvent N-methylpyrrolidone (NMP) to obtain a positive electrode slurry. The positive electrode slurry was coated on a positive electrode current collector aluminum foil and dried to obtain a positive electrode plate. In a glove box filled with argon, the positive electrode plate and the prepared foam metal substrate were assembled into a coin cell. The electrolyte salt of the electrolyte solution was LiFSI with a concentration of 1 mol/L, and the solvent of the electrolyte solution was dimethoxyethane (DME). The separator was a PE film with a thickness of 12 µm.

Cycling performance test: At 25°C, the assembled coin cell was left to stand for 12 hours, then charged at a constant current of 0.2C to 3.65 V, followed by constant voltage charging at 3.65 V to 0.05C. The coin cell was left to stand for 10 minutes, then discharged at a constant current of 1C to 2 V. The coin cell was charged and discharged according to the above method, and the cycle number was recorded at which the discharge capacity decayed to 40% of the initial discharge capacity. During testing, the number of coin cell samples may be 6 or more, and the average value of the test results was taken.

Rate performance test: At 25°C, the assembled coin cell was left to stand for 12 hours and charged at constant currents of 1C and 0.2C to 3.65 V respectively to obtain a 1C charge capacity and a 0.2C charge capacity. The ratio of the 1C charge capacity to the 0.2C charge capacity was used to characterize the rate performance of the coin cell. A value closer to 1 indicates better rate performance of the coin cell. During testing, the number of coin cell samples may be 6 or more, and the average value of the test results was taken.

**Table 2**

| No. | Number of cycles (cycles) | 1C charge capacity / 0.2C charge capacity |
|---|---|---|
| Comparative Example 1 | 20 | 91.20% |
| Comparative Example 2 | 36 | 98.40% |
| Example 1 | 44 | 92.10% |
| Example 2 | 48 | 93.50% |
| Example 3 | 56 | 94.10% |
| Example 4 | 53 | 94.20% |
| Example 5 | 54 | 95.20% |
| Example 6 | 51 | 95.80% |
| Example 7 | 56 | 96.20% |
| Example 8 | 57 | 96.60% |
| Example 9 | 53 | 97.10% |
| Example 10 | 45 | 98.30% |

From the test results in Table 1 and Table 2, it can be seen that by adjusting the mass-specific electrochemically active surface area of the foam metal substrate to 2.5 cm²/g to 20 cm²/g and the electrochemically active volumetric surface area to 22 cm²/cm³ to 180 cm²/cm³, the battery can have both long cycle life and high rate charging capacity retention rate.

The foam metal substrate prepared in Comparative Example 1 exhibited an excessively small electrochemically active specific surface area and uneven pore diameter distribution, resulting in uneven current density distribution on the surface of the negative electrode, thereby leading to poor cycling performance and high rate charge capacity retention rate of the battery.

The foam metal substrate prepared in Comparative Example 2 exhibited an excessively large electrochemically active specific surface area, which corresponded to a high content of small pores in the foam metal substrate. During battery charging, the pores on the side of the negative electrode close to the separator may be quickly blocked by deposited metal, ions in the electrolyte solution were difficult or even unable to replenish to the internal positions of the negative electrode, reducing the space utilization of the negative electrode and leading to poor electrolyte solution wettability of the negative electrode, thereby deteriorating the cycling performance of the battery.

Next, the first-cycle coulombic efficiency of the battery was also tested. At 25°C, the assembled coin cell was left to stand for 12 hours and charged at a constant current of 0.1C to 3.65 V, then charged at a constant voltage of 3.65 V to 0.05C to obtain a charge capacity; the coin cell was left to stand for 10 min, then discharged at a constant current of 0.2C to 2 V to obtain a discharge capacity. First-cycle coulombic efficiency = discharge capacity / charging capacity. The test results are shown in Table 3.

**Table 3**

| No. | First-cycle coulombic efficiency |
|---|---|
| Example 1 | 93.20% |
| Example 2 | 93.00% |
| Example 3 | 92.60% |
| Example 4 | 92.50% |
| Example 5 | 92.20% |
| Example 6 | 86.90% |
| Example 7 | 86.20% |
| Example 8 | 84.30% |
| Example 9 | 80.60% |
| Example 10 | 77.20% |

From the test results in Table 3, it can be seen that by further adjusting the mass-specific electrochemically active surface area and electrochemically active volumetric surface area of the foam metal substrate, the battery can achieve high coulombic efficiency while maintaining good cycling performance and rate performance. This is because more active ions need to be consumed to activate the deposition sites on the surface of the negative electrode during the first charge of the battery as the electrochemically active specific surface area of the foam metal substrate increases, thereby decreasing the first-cycle coulombic efficiency of the battery.

It should be noted that the present application is not limited to the above embodiments. The above embodiments are merely examples, and embodiments having substantially the same configuration and achieving the same effects as the technical solutions within the scope of the present application are included in the technical scope of the present application. Additionally, without departing from the gist of the present application, various modifications that can be conceived by those skilled in the art and other configurations constructed by combining some constituent elements of the embodiments are also included in the scope of the present application.

## Claims

1. A negative electrode current collector, wherein the negative electrode current collector comprises a foam metal substrate, and the foam metal substrate has a mass-specific electrochemically active surface area of 2.5 cm²/g to 20 cm²/g and an electrochemically active volumetric surface area of 22 cm²/cm³ to 180 cm²/cm³.

2. The negative electrode current collector according to claim 1, wherein the foam metal substrate has a mass-specific electrochemically active surface area of 3.2 cm²/g to 10 cm²/g and an electrochemically active volumetric surface area of 29 cm²/cm³ to 90 cm²/cm³.

3. The negative electrode current collector according to claim 2, wherein the foam metal substrate has a mass-specific electrochemically active surface area of 3.2 cm²/g to 5 cm²/g and an electrochemically active volumetric surface area of 29 cm²/cm³ to 45 cm²/cm³.

4. The negative electrode current collector according to any one of claims 1 to 3, wherein
the number of pores having a pore diameter between 0.5 times an average pore diameter D_{avg} and 1.5 times the average pore diameter D_{avg} in the foam metal substrate is 80% to 90% of a total number of pores in the foam metal substrate; and/or
the number of pores having a pore diameter less than 0.5 times the average pore diameter D_{avg} in the foam metal substrate is 4.5% to 12% of the total number of pores in the foam metal substrate; and/or
the number of pores having a pore diameter greater than 1.5 times the average pore diameter D_{avg} in the foam metal substrate is 2% to 12% of the total number of pores in the foam metal substrate.

5. The negative electrode current collector according to any one of claims 1 to 4, wherein
the foam metal substrate has an average pore diameter D_{avg} of 120 µm to 290 µm; and/or
the foam metal substrate has a maximum pore diameter Dₘₐₓ of 200 µm to 500 µm.

6. The negative electrode current collector according to any one of claims 1 to 5, wherein the foam metal substrate has a ligament width of 5 µm to 100 µm.

7. The negative electrode current collector according to any one of claims 1 to 6, wherein the foam metal substrate has a pore density of 135 PPI to 200 PPI.

8. The negative electrode current collector according to any one of claims 1 to 7, wherein the foam metal substrate has a porosity of 65% to 91%.

9. The negative electrode current collector according to any one of claims 1 to 8, wherein the foam metal substrate has an open-cell structure with an open-cell rate greater than or equal to 98%.

10. The negative electrode current collector according to any one of claims 1 to 9, wherein the foam metal substrate has a thickness of 80 µm to 1000 µm.

11. The negative electrode current collector according to any one of claims 1 to 10, wherein metal elements in the foam metal substrate comprise one or more of copper, nickel, titanium, aluminum, cobalt, iron, manganese, tin, gold, silver, chromium, zinc, cadmium, lead, platinum, antimony, bismuth, gallium, indium, or palladium.

12. The negative electrode current collector according to any one of claims 1 to 11, wherein the negative electrode current collector further comprises an alkali metal affinity layer located on a surface of the foam metal substrate.

13. The negative electrode current collector according to claim 12, wherein
the alkali metal affinity layer comprises one or more of Cu₂O or Li₃N; and/or
the alkali metal affinity layer has a thickness of 50 nm to 5 µm.

14. A battery cell comprising the negative electrode current collector according to any one of claims 1 to 13.

15. The battery cell according to claim 14, wherein the battery cell comprises at least one of a negative electrode-free lithium metal battery cell or a negative electrode-free sodium metal battery cell.

16. A battery comprising the battery cell according to claim 14 or 15.

17. An electric apparatus comprising the battery according to claim 16, wherein the battery is used to supply electrical energy.
